(19) Europäisches Patentamt
European Patent Office
Office européen des brevets

(11) **EP 2 793 328 B1**

(12) **EUROPÄISCHE PATENTSCHRIFT**

(45) Veröffentlichungstag und Bekanntmachung des Hinweises auf die Patenterteilung:
**22.08.2018   Patentblatt 2018/34**

(51) Int Cl.:
*H01S 3/00* *(2006.01)*          *H01S 3/094* *(2006.01)*
*H01S 3/0941* *(2006.01)*      *H01S 3/131* *(2006.01)*
*H01S 3/30* *(2006.01)*         *H04B 10/2575* *(2013.01)*
*H04B 10/90* *(2013.01)*

(21) Anmeldenummer: **13163794.4**

(22) Anmeldetag: **15.04.2013**

(54) **Durchstimmbare Erzeugung von Millimeterwellen und Terahertzwellen**

Tunable generation of millimetre waves and terahertz waves

Génération accordable d'ondes millimétriques et d'ondes teraherziennes

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**22.10.2014   Patentblatt 2014/43**

(73) Patentinhaber: **Deutsche Telekom AG**
**53113 Bonn (DE)**

(72) Erfinder: **Schneider, Thomas**
**14552 Michendorf OT Wilhelmshorst (DE)**

(74) Vertreter: **Braun-Dullaeus, Karl-Ulrich**
**Braun-Dullaeus Pannen**
**Patent- und Rechtsanwälte**
**Platz der Ideen 2**
**40476 Düsseldorf (DE)**

(56) Entgegenhaltungen:
DE-A1-102006 023 601      DE-A1-102007 058 038

- SCHNEIDER T ET AL: "Theoretical and experimental investigation of Brillouin scattering for the generation of millimeter waves", JOURNAL OF THE OPTICAL SOCIETY OF AMERICA - B, OPTICAL SOCIETY OF AMERICA, WASHINGTON, US, Bd. 23, Nr. 6, 1. Juni 2006 (2006-06-01), Seiten 1012-1019, XP002524877, ISSN: 0740-3224, DOI: 10.1364/JOSAB.23.001012

- BORJA VIDAL ET AL: "Microwave generation through photonic octupling based on phase modulation and brillouin amplification", MICROWAVE PHOTONICS, 2011 INTERNATIONAL TOPICAL MEETING ON&MICROWAVE PHOTONICS CONFERENCE, 2011 ASIA-PACIFIC, MWP/APMP, IEEE, 18. Oktober 2011 (2011-10-18), Seiten 125-128, XP032028600, DOI: 10.1109/MWP.2011.6088685 ISBN: 978-1-61284-716-0

- ORTEGA D R ET AL: "Diode laser stabilization using pound drever Hall technique", ANNALS OF OPTICS, , Bd. 5 1. Januar 2003 (2003-01-01), XP002564846, Gefunden im Internet: URL:http://www.sbf1.sbfisica.org.br/procs/2003/R_estendido/c55.pdf [gefunden am 2013-08-19]

- MARTELLI P ET AL: "Polarization pulling induced by Raman amplification in telecommunication optical fibers", LASERS AND ELECTRO-OPTICS, 2009 AND 2009 CONFERENCE ON QUANTUM ELECTRONICS AND LASER SCIENCE CONFERENCE. CLEO/QELS 2009. CONFERENCE ON, IEEE, PISCATAWAY, NJ, USA, 2. Juni 2009 (2009-06-02), Seiten 1-2, XP031520505, ISBN: 978-1-55752-869-8

- NAWAWI N M ET AL: "Investigation of Stimulated Brillouin Scattering for the Generation of Millimeter Waves for Radio over Fiber System", TELECOMMUNICATION TECHNOLOGIES 2008 AND 2008 2ND MALAYSIA CONFERENCE ON PHOTONICS. NCTT-MCP 2008. 6TH NATIONAL CONFERENCE ON, IEEE, PISCATAWAY, NJ, USA, 26. August 2008 (2008-08-26), Seiten 33-36, XP031449169, ISBN: 978-1-4244-2214-2

EP 2 793 328 B1

**Beschreibung**

Die Erfindung betrifft ein Verfahren und eine Vorrichtung zur Erzeugung von Millimeter- und/oder von Terahertzwellen durch Überlagerung zweier optischer Wellen unterschiedlicher Frequenz.

In einem solchen Verfahren wird zunächst ein Spektrum unterschiedlicher, insbesondere äquidistanter, Frequenzen (Frequenzkamm) erzeugt und in Ausbreitungsrichtung in ein optisch nichtlineares Medium (Brillouin Medium), beispielsweise in eine Singlemode Faser, eingekoppelt wird. Andererseits werden zwei Pumpwellen erzeugt und entgegen der Ausbreitungsrichtung in das Medium eingekoppelt. Dabei werden die Wellenlängen der Pumpwellen derart eingestellt, dass sie zwei Frequenzen des Frequenzkamms vermittels stimulierter Brillouin Streuung (SBS) verstärken. Durch eine geeignete elektronische Schaltung werden die beiden Pumpwellen auf die beiden zu verstärkenden Seitenbänder gelocked. Die Polarisation der Pumpwellen und des Frequenzkamms wird so eingestellt, dass alle nicht verstärkten Frequenzanteile des Frequenzkamms durch einen Polarisationsfilter am Ausgang unterdrückt werden. Die beiden verstärkten Frequenzen werden in Ausbreitungsrichtung aus dem Medium ausgekoppelt und in einem optischen Sensor, insbesondere einer Photodiode, überlagert. Diese Überlagerung weist eine Differenzfrequenz im Millimeter- oder Terahertz Bereich auf, die sich über ein Ausgangssignal des Sensors auskoppeln und beispielsweise mittels einer Antenne versenden lässt. Ein solches Verfahren ist in "Theoretical and experimental investigation of Brillouin scattering for the generation of millimeter waves" (T. Schneider et al in Journal of the optical society of america - B, optical society of america, Washington, US, Bd. 23, Nr. 6, 1. Juni 2006, S. 1012-1019) beschrieben.

Bekanntermaßen gibt es für Millimeterwellen (30 - 300 GHz) und Terahertzwellen (300 GHz - 30 THz) eine Vielzahl von Anwendungen. So ist es beispielsweise möglich, mit Wellen dieser Wellenlängenbereiche hohe Bitraten drahtlos zu übertragen oder Bilder durch Nebel, Staub und Dunst hindurch aufzunehmen. Da einige chemische Verbindungen, zu denen auch Drogen und Sprengstoffe gehören, Resonanzen im Terahertz - Bereich des elektromagnetischen Spektrums aufweisen, lassen sich diese durch Anregung in diesem Frequenzbereich nachweisen. Durchstimmbare Millimeter- und Terahertzquellen hoher Qualität, d.h. hoher Frequenz-, Phasen- und Amplitudenstabilität, geringer Bandbreite und geringem Phasenrauschen, sind daher von großem Interesse für derartige Anwendungen.

Da der fragliche Frequenzbereich zwischen dem Bereich der Radiowellen und dem optischen Bereich liegt, wurden bisher elektronische Methoden, insbesondere zur Erzeugung von Millimeterwellen und von THz-Wellen tiefer Frequenzen, und optische Methoden für höhere Frequenzen vorgeschlagen. Beispielsweise lassen sich "high electron mobility" Transistoren auf GaAs-Basis zur Erzeugung von Millimeterwellen einsetzen, wie unter http://www3.ihe.unikarlsruhe.de/index.php?lang=en ersichtlich ist. Die dort offenbarte Methode ist jedoch auf wenige Millimeterwellen-Träger-Frequenzen beschränkt.

Bei einer anderen bekannten Methode werden zwei Laser an einer Photodiode heterodyn überlagert. Auf Grund der Intensitätsabhängigkeit des Ausgangsstroms dieser Photodiode ist dieser proportional zur Frequenzdifferenz zwischen den beiden Lasern. Dabei ist eine Photodiode, wie jedes andere optische Instrument, nicht in der Lage, das elektrische Feld der auftreffenden optischen Welle zu messen. Stattdessen misst eine Photodiode die Intensität der Welle, die quadratisch von der Amplitude des Feldes abhängt. Überlagern sich in der Photodiode zwei optische Felder mit den optischen Frequenzen $f_1$ und $f_2$, so folgt aus dieser quadratischen Abhängigkeit, dass Wellen mit Frequenzen von $2f_1$, $2f_2$, $f_1+f_2$ und $f_1-f_2$ entstehen. Wegen der begrenzten Bandbreite ist die Photodiode jedoch nur in der Lage, der Differenzfrequenz $f_1-f_2$ zwischen beiden Wellen zu folgen. Liegt die Differenz der beiden optischen Wellen $f_c = f_1 - f_2$ im mm oder THz - Bereich, so schwingt auch der Ausgangsstrom der Photodiode im mm oder THz - Bereich. Wird mit diesem Strom eine Antenne getrieben, so lässt sich die entsprechende Welle abstrahlen, wobei ein Durchstimmen der Frequenz einfach durch eine Änderung der Frequenz einer oder beider optischen Wellen möglich ist.

Auf diesem grundsätzlichen Prinzip arbeiten viele bekannte Systeme zur THz-Erzeugung.

Wenn allerdings beide Laser völlig unabhängig voneinander schwingen, hat das Ausgangssignal eine relativ hohe Bandbreite und ein hohes Amplituden- und Phasenrauschen. Eine ideale Quelle, die ein mm- oder THz-Signal mit der Amplitude A und der Frequenz $f_c$ erzeugt, hat als Ausgangssignal

$$V(t) = A \cos (2\pi f_c t) \qquad (1)$$

Wenn hingegen beide Laser völlig unabhängig voneinander sind, ergibt sich als Ausgangssignal:

$$V(t) = A(t) \cos (2\pi f_c(t) t + \phi(t)) + n(t) \qquad (2)$$

Dabei bezeichnet $A(t)$ das durch die Unabhängigkeit der Amplituden der von beiden Lasern erzeugten Felder entstehende Amplitudenrauschen, $f_c(t)$ ein durch unabhängige Frequenzänderungen in den Lasern erzeugtes Frequenzrauschen, $n(t)$ zusätzliches weißes Rauschen und $\phi(t)$ das Phasenrauschen. Letzteres entspricht einer stochastischen Änderung der Phase des Signals und damit einer Verbreiterung des Spektrums. Auf Grund dieser Rauschterme ist die bislang bekannte Methode für viele Anwendungen uninteressant. Ersichtlich entsteht eine Millimeter- oder Terahertz-Welle mit hoher Qualität nur dann, wenn die durch beide Laser erzeugten optischen Wellen eine feste Frequenz- Amplituden- und Phasenbeziehung zueinander haben.

Da in den bekannten Verfahren beide Laser unabhängig voneinander schwingen, ist die Qualität der so erzeugten Wellen gering. Zudem beträgt die Bandbreite des so erzeugten Signals auf Grund der Unabhängigkeit der beiden Laser mehrere MHz und das Signal weist ein hohes Phasenrauschen auf, so dass diese Methode insgesamt für die wenigsten Anwendungen einsetzbar ist.

Eine Millimeter- oder Terahertz-Welle mit ausreichend hoher Qualität entsteht nur, wenn die durch die beiden Laser erzeugten optischen Wellen eine feste Frequenz- und Phasenbeziehung zueinander haben. Eine solche Beziehung weisen einzelne Wellen auf, wenn sie beispielsweise mittels einer einzigen Laserquelle durch externe Modulation erzeugt werden. Aus US 2008/0310464 ist es bekannt, einen optischen Frequenzkamm durch die externe Modulation eines Lasers zu erzeugen. Dazu wird ein Intensitätsmodulator benutzt, den ein elektrischer Generator ansteuert. Zwei der so erzeugten Seitenbänder werden mit Hilfe der stimulierten Brillouin Streuung (SBS) durch zwei gegenläufige Pumpwellen verstärkt und erzeugen durch Überlagerung in einer Photodiode die gewünschte Millimeterwelle. Da beide Seitenbänder aus derselben Quelle stammen, haben sie eine feste Frequenz- und Phasenbeziehung zueinander und erzeugen so eine Welle mit geringem Phasenrauschen.

Allerdings sind die benötigten Modulatoren nur bis 40 GHz kommerziell erhältlich und müssen als teure Spezialanfertigungen angeschafft werden, wenn sie mit Frequenzen von höchstens 100 GHz arbeiten sollen. Wird das jeweils dritte Seitenband verstärkt, so können mit einem 40 GHz Modulator Frequenzen von höchstens 240 GHz erzeugt werden. Zudem wird bei dieser Methode ein qualitativ hochwertiger Modulator zur Modulation der Frequenzen bis zu 40 GHz benötigt. Ein weiteres Problem liegt darin, dass der Intensitätsunterschied zwischen den verstärkten und den nicht verstärkten Seitenbändern nur durch den Verstärkungsgewinn mit Hilfe der SBS für die gewünschten, hingegen die Faserdämpfung für die ungewollten Seitenbänder entsteht. Ein auf diese Weise erzeugtes Signal kann daher einen relativ hohen Untergrund aufweisen. Zudem werden die beiden gegenläufigen Pumpwellen, die für eine Verstärkung der beiden Seitenbänder sorgen, durch zwei unabhängige Laser erzeugt. Diese können mit der Zeit ihre Ausgangswellenlänge ändern und so für eine Instabilität des erzeugten Signals sorgen.

Die DE 10 2006 023 601 A1 beschreibt ganz allgemein ein Lasersystem mit einem Kurzpulslaser.

Aufgabe der Erfindung ist es nunmehr, ein einfach und kostengünstig umzusetzendes Verfahren zur Erzeugung von qualitativ hochwertigen Millimeter- und Terahertzwellen vorzuschlagen. Zudem ist es Aufgabe der Erfindung, ein entsprechendes System zu schaffen.

Gelöst werden diese Aufgaben durch das Verfahren nach Anspruch 1 und das System nach Anspruch 4. Die jeweiligen Unteransprüche beschreiben vorteilhafte Ausführungsformen.

Entsprechend der vorliegenden Erfindung werden ebenfalls zwei Seitenbänder eines Frequenzkamms mit Hilfe der stimulierten Brillouin Streuung (SBS) verstärkt. Dabei liegt der Grundgedanke des erfindungsgemäßen Verfahrens und der Vorrichtung zur Erzeugung von Millimeter (mm) - Wellen und Terahertz- (THz) - Wellen aus zwei optischen Wellen darin, das oben beschriebene Verfahren der heterodynen Überlagerung zweier Wellen insofern zu verbessern, als der Frequenzkamm mittels einer modengekoppelten Laserquelle, insbesondere mittels eines modengekoppelten Kurzpuls-Lasers, erzeugt wird. Außerdem werden die Pumpwellen erfindungsgemäß auf die beiden zu verstärkenden Frequenzen des Frequenzkammes stabilisiert, während gleichzeitig die nicht zu verstärkenden Frequenzen des Frequenzkamms insbesondere durch den polarization pulling Effekt der SBS unterdrückt werden.

Mit dieser Vorgehensweise werden die oben genannten Nachteile vermieden. Dabei haben alle Seitenbänder des der modengekoppelten Laserquelle entnommenen Frequenzkamms eine feste Frequenz- und Phasenbeziehung, so dass zunächst die Grundlage für die Erzeugung hochwertiger Millimeter- und Terahertz-Wellen gegeben ist. Im Gegensatz zu der oben erwähnten Methode ist die maximal erzeugbare Frequenz $f_{max}$ auch nicht von zusätzlichem teurem Equipment abhängig, sondern entsprechend $f_{max} = C/\Delta\tau$ invers proportional zur zeitlichen Dauer $\Delta\tau$ der Pulse, wobei C eine Konstante ist, die von der Form der Pulse abhängt. Mit einem Femtosekunden-Laser lassen sich dementsprechend Wellen mit Frequenzen bis zu 30 THz erzeugen. Wird das Spektrum des Lasers durch nichtlineare Methoden vergrößert, so lässt sich dieser Bereich sogar noch drastisch erweitern. Dazu reicht der modengekoppelte Laser aus, während der Einsatz eines hochwertigen Modulators entfällt. Als modengekoppelte Laserquellen lassen sich Halbleiter- oder Faserlaser verwenden, so dass das System kompakt und leicht aufgebaut werden kann.

Die ungewollten Seitenbänder werden bei der Erfindung vorteilhafterweise durch den "polarization pulling" Effekt ("PP") aus dem an der Photodiode anliegenden Signal herausgefiltert, so dass das Signal kaum Untergrund aufweist. Die Pumpwellen werden erfindungsgemäß auf die zu verstärkenden Seitenbänder fixiert, so dass stabile und in ihrer Leistung oder Frequenz nicht schwankende Wellen entstehen. Dies geschieht vorteilhafterweise unter Einsatz des Pound-Drever-Hall- oder anderer geeigneter Verfahren.

Weitere Merkmale und Vorteile ergeben sich aus der nachfolgenden Beschreibung anhand der Figuren. Es zeigen:

**Figur 1**   den generellen Aufbau des Systems,

**Figur 2**   ein Spektrum eines Kurzpuls-Lasers (ps-Dioden-Laser) und zwei mit SBS verstärkte Moden mit einem Frequenzabstand von rund 1 THz,

**Figur 3**   einen Ausschnitt des Spektrums des Kurzpuls-Lasers und zwei daraus verstärkte Moden mit einem Frequenzabstand von 100 GHz,

**Figur 4**   Spektrum nach Figur 2, jedoch mit polarization pulling und

**Figur 5**   Spektrum nach Figur 3, jedoch mit polarization pulling.

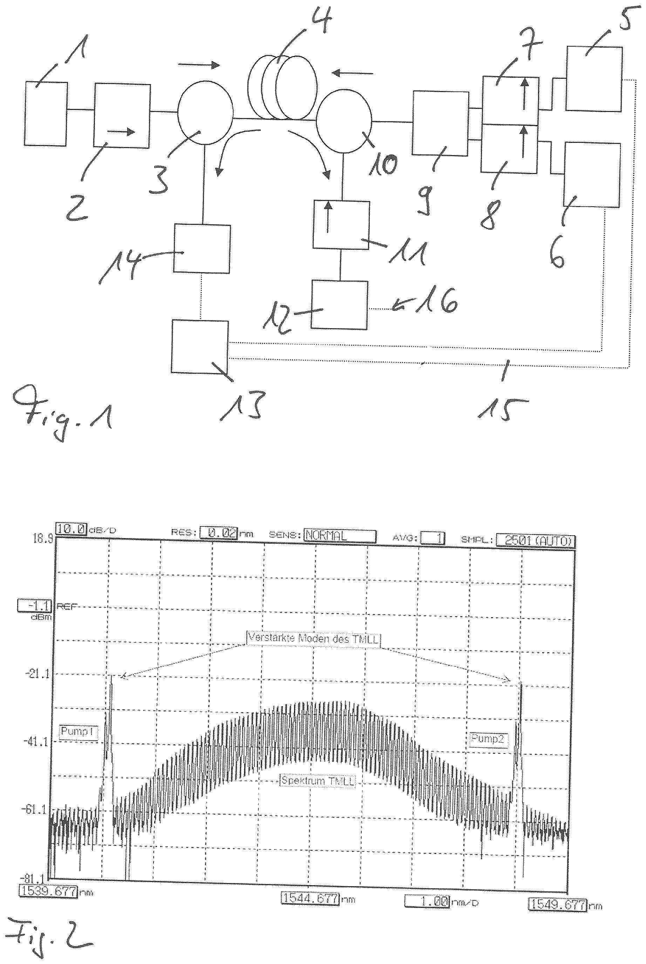

Mit dem in Figur 1 dargestellten Aufbau wird zunächst ein Frequenzkamm durch einen Kurzpuls-Laser 1 erzeugt, über ein Polarisationsstellglied 2 geführt und über einen ersten Zirkulator 3 in ein Brillouin Medium 4 eingespeist. Damit bewegt sich der Kamm in Figur 1 von links nach rechts. In Figur 1 bedeuten durchgezogene Linien optische Verbindungen und punktierte Linien elektrische Verbindungen.

Pulslaser erzeugen Pulssequenzen respektive Pulsfolgen, deren Spektrum aus einzelnen spektralen Linien, dem so genannten Frequenzkamm, besteht. Da die Phasen der einzelnen Linien voneinander abhängig sind, werden solche Kurzpuls-Laser auch als modengekoppelte Laser bezeichnet. Der Frequenzabstand zwischen den einzelnen Linien im Kamm entspricht der Repetitionsrate bzw. der inversen Zeit zwischen den Pulsen, die wiederum der Zeit eines vollen Umlaufs im Resonator des Lasers entspricht. Die Bandbreite über die sich die einzelnen Frequenzen spannen, ist proportional zur inversen Dauer der Pulse. Der Proportionalitätsfaktor hängt dabei von der Form der Pulse ab. Für eine Abschätzung genügt es, wenn von einem Proportionalitätsfaktor "1" ausgegangen wird. Dementsprechend erhält man aus einem Femtosekunden-Laser, der Ausgangspulse mit einer zeitlichen Dauer von 30 fs = $3 \times 10^{-14}$s mit einer Repetitionsrate von 80 MHz = $8 \times 10^7$ s$^{-1}$ (typische Werte für kommerziell erhältliche Faser-fs-Laser) erzeugt, einen Frequenzkamm einer spektralen Breite von 33 THz = $3.3 \times 10^{13}$s$^{-1}$.

Die einzelnen Frequenzen haben einen Frequenzabstand von 80 MHz, so dass das Spektrum des Pulses und damit der Frequenzkamm aus 412.500 Linien besteht, deren Frequenzen eine feste Phasen- und Frequenzbeziehung zueinander haben. Der Frequenzabstand wird durch die Repetitionsrate des Lasers bestimmt und lässt sich sehr genau stabilisieren. Da die Form der Pulse stabil bleibt, ändern sich auch deren Amplituden nicht. Daraus folgt, dass $A(t)$, $f_c(t)$ und $\phi(t)$ in Gleichung (2) minimal werden oder ganz entfallen. Ein durch die Überlagerung zweier Moden des Frequenzkamms erzeugtes mm- oder THz-Signal hat demnach eine besondere hohe Qualität.

Die Bandbreite des Kamms und damit auch der erzeugbare Frequenz-Bereich lässt sich erweitern, indem durch nichtlineare Effekte, wie die Selbstphasenmodulation und die Vierwellenmischung, neue Frequenzen zum Kamm hinzugefügt werden. Der Laser selbst muss keine kurzen Pulse liefern. Es genügt, wenn die Frequenzen im Ausgangsspektrum des Lasers vorhanden sind.

Der in Figur 1 gezeigte Aufbau ermöglicht eine Verstärkung bestimmter Frequenzen des Frequenzkamms mittels stimulierter Brillouin Streuung (SBS). Dabei kann die SBS als ein Verstärkungsprozess mit äußerst geringer Bandbreite betrachtet werden. Eine optische Pumpwelle, die sich in einem Brillouin Medium ausbreitet, verstärkt ein gegenläufiges, in der Frequenz nach unten verschobenes Signalspektrum. Als Brillouin Medium dient im System nach Figur 1 eine konventionelle standard-single-mode-Faser (SSMF) 4, mit einer Länge von mehreren Kilometern, um die benötigten Pumpleistungen gering zu halten. Die Pumpwellen werden von zwei Laserdioden erzeugt (Pumplaser 5 und 6), über jeweils ein Polarisationsstellglied 7 und 8 geführt, mittels eines 3 dB-Kopplers 9 zusammengefügt und über einen zweiten Zirkulator 10 in die Faser 4 eingespeist, so dass sie sich gegenläufig zum Frequenzkamm ausbreiten (hier von rechts nach links).

Die Pumpleistung beträgt typischerweise mehrere Milliwatt. Die Pumpwellenlänge liegt typischerweise bei 1550 nm. Für eine Pumpwellenlänge von 1550 nm beträgt die Frequenzverschiebung zwischen der Pumpwelle und dem Signalspektrum in einer SSMF rund 11 GHz und das Verstärkungsspektrum hat eine Bandbreite von 10 - 30 MHz. Die Wellenlänge der Pumpwellen wird nun so eingestellt, dass sie genau zwei der Frequenzen aus dem Frequenzkamm über den Effekt der SBS in der SSMF verstärken. Die beiden verstärkten Frequenzen des Kamms gelangen über den Zirkulator 10 (siehe Pfeil) über einen Polarisationsfilter 11 zu einer zweiten Photodiode 12 und erzeugen darin auf Grund der heterodynen Überlagerung das mm- oder THz-Signal, das über den Ausgang 16 abgenommen und beispielsweise über eine nicht dargestellte Antenne ausgestrahlt werden kann

Durch ein Ändern der Pumpwellenlänge eines oder beider Pumplaser und/oder einer Änderung der Repetitionsrate des Kurzpulslasers kann jede Frequenz zwischen der doppelten Bandbreite der SBS und der gesamten Bandbreite des Frequenzkamms erzeugt werden. Im obigen Beispiel eines 30 fs - Lasers kann somit jede Frequenz zwischen 20 MHz und 33 THz erzeugt werden. Der erfindungsgemäße Generator überspannt damit einen Frequenzbereich von 6 Größenordnungen. Zusätzlich kann jede Frequenz des Kamms einzeln verstärkt werden, so dass der Generator auch Frequenzen im 33 THz breiten optischen Bereich des Kamms erzeugen kann.

Figur 2 zeigt, wie zwei der Moden eines mit einem Pikosekunden-Diodenlasers erzeugten Spektrums mit der Methode der SBS verstärkt wurden. Der Abstand zwischen den beiden Moden beträgt rund 1 THz. Wie der Abbildung zu entnehmen ist, beträgt der Leistungsunterschied zwischen den beiden verstärkten Moden am Rand des Spektrums und den starken Moden in der Mitte lediglich 5 dB. Ein daraus erzeugtes THz-Signal hätte einen sehr hohen Untergrund.

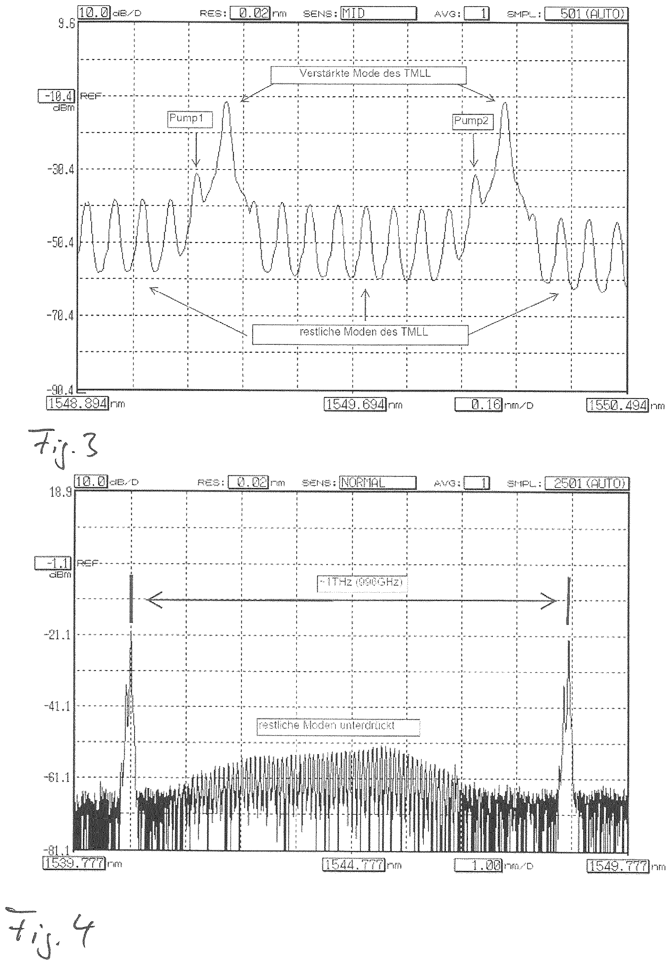

Wie aus Figur 3 ersichtlich, stellt sich das für mm-Signale anders dar. In der Figur ist ein 1.6 nm breiter Ausschnitt aus dem Spektrum des Kurzpulslasers zu sehen, aus dem zwei Moden mit einem Frequenzabstand von 100 GHz verstärkt wurden. Der Leistungsunterschied zwischen den verstärkten und nicht verstärkten Moden beträgt 30 dB.

Vorteilhafterweise wird zur besseren Trennung der Leistungen zwischen verstärkten und nicht verstärkten Moden auch für große Frequenzabstände der bekannte Effekt des "polarization pulling" (PP) verwendet. PP bedeutet, dass bei der SBS die Pumpwellen die Polarisation des verstärkten Signalanteils in die Richtung ihrer Polarisation ziehen. Wenn sich also vor der Photodiode ein Polarisationsfilter befindet, das so eingestellt ist, dass es genau senkrecht zur Polarisation der Signalwelle steht, so wird an der Photodiode kein Signal anliegen. Wird dann eine gegenläufige Pumpwelle eingespeist, die parallel zum Ausgangsfilter polarisiert ist, so verstärkt diese die Signalwelle über die SBS und dreht gleichzeitig ihre Polarisation. Da die Polarisation der verstärkten Signalwelle dann parallel zur Polarisation des Ausgangsfilters ist, steht am Ausgang des Filters ein Signal bereit.

Mit dem System nach Figur 1 wird das PP umgesetzt, indem der durch den Kurzpulslaser erzeugte Frequenzkamm mit Hilfe des Polarisationsstellers 2 so polarisiert wird, dass seine Polarisation senkrecht zu der des Polarisationsfilters 11 steht (siehe Pfeile in den Blöcken). Ohne Verstärkung durch die SSMF 4 liegt also kein Signal an der Photodiode 12 an. Die beiden durch die Pumplaser 5 und 6 erzeugten Pumpwellen werden über die Polarisationssteller 7 und 8 so eingestellt, dass ihre Polarisation parallel zum Polarisationsfilter 11 steht. Dementsprechend wird die Polarisation der beiden durch SBS verstärkten Moden ebenfalls parallel zum Polarisationsfilter 11 gedreht, so dass nur diese beiden Moden den Polarisationsfilter 11 passieren können und alle anderen nicht verstärkten Moden unterdrückt werden.

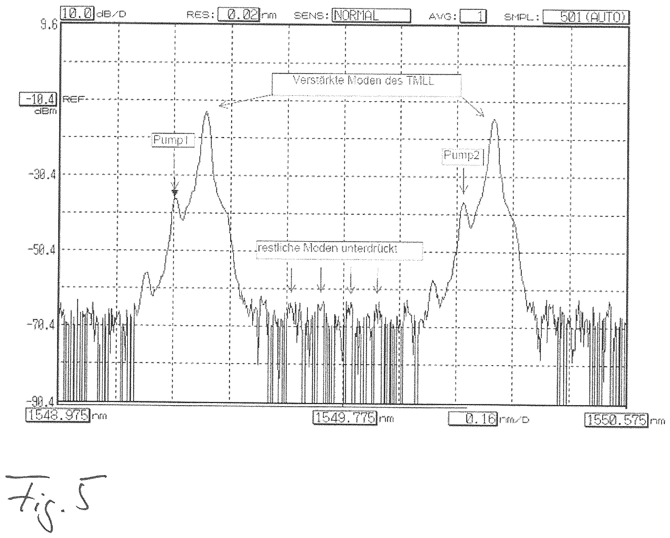

Figur 4 zeigt denselben Fall wie Figur. 2 jedoch mit polarization pulling. Wie aus Figur 4 ersichtlich, sind die ungewollten Moden, die in Figur 2 nur rund 5 dB kleiner waren, als die beiden verstärkten, jetzt um 30 dB unterdrückt. Die starke Unterdrückung der ungewollten Moden wird noch deutlicher bei der Erzeugung von mm-Wellen, wie Figur 5 zeigt. Die unterdrückten Moden liegen hier 50 dB unter den verstärkten und verschwinden damit im Rauschen.

Zur Stabilisierung der Pumpwellen auf die zu verstärkenden Seitenbänder wird im vorliegenden Ausführungsbeispiel das Pound-Drever-Hall-Verfahren (PDH), benannt nach seinen Entdeckern Robert Pound, Ronald Drever und John Lewis Hall, eingesetzt. Dieses wird üblicherweise dazu benutzt, die Ausgangsfrequenz eines Lasers mit Hilfe eines Resonators zu stabilisieren. Misst man die Reflektivität eines Resonators, so ergibt sich genau bei seiner Resonanzfrequenz ein schmalbandiger Einbruch bzw. eine Vertiefung in der Funktion. Das PDH-Verfahren stabilisiert den Laser durch eine Messung dieser Vertiefung und durch Rückkopplung auf den Laser. Elektronische Schaltungen für das PDH-Verfahren sind bekannt und kommerziell erhältlich.

Im Gegensatz zum bekannten Einsatz, werden erfindungsgemäß die beiden Pumplaser 5 und 6 über den Effekt der SBS auf die beiden zu verstärkenden Seitenbänder des Frequenzkamms stabilisiert. Dies geschieht über die in Figur 1 dargestellte PDH-Schaltung 13. Die beiden nach der SBS-Verstärkung vorliegenden Pumpwellen werden über den Zirkulator 3 ausgekoppelt. Deren Intensität kann mit einer ersten Photodiode 14 gemessen werden. Durch eine Phasen- oder Frequenzmodulation mit unterschiedlicher Frequenz können die Intensitäten beider Pumplaser unabhängig voneinander über die Photodiode 14 bestimmt werden. Die Funktionsweise wird an dieser Stelle jedoch nur mit einem Pumplaser erläutert.

Liegt die Frequenz des Pumplasers so, dass kein Signal in die Bandbreite seiner Verstärkung fällt, dann liegt an der Photodiode 14 eine Intensität an, die zu einem bestimmten Ausgangsstrom führt. Ändert sich die Frequenz des Pumplasers derart, dass er einen spektralen Anteil des Seitenbandes verstärkt, dann wird optische Energie von der Pumpwelle zur Signalwelle transferiert. Die Intensität des Pumplasers an der Photodiode 14 und damit der Ausgangsstrom sinken. Liegt die Frequenz des Pumplasers so, dass es zu einer maximalen Verstärkung kommt, dann erreicht der Ausgangsstrom sein Minimum. Dieses Minimum dient - wie der Einbruch der Reflektivität des Resonators beim konventionellen PDH-Verfahren - zur Stabilisierung der beiden Pumplaser 5 und 6. Dies geschieht über den PDH-Schaltkreis 13, der über den elektrischen Weg 15 den Eingangsstrom der beiden Pumplaser 5 und 6 steuert.

## Patentansprüche

1. Verfahren zur Erzeugung von Millimeter- oder Terahertzwellen durch Überlagerung zweier optischer Wellen unterschiedlicher Frequenz,
   wobei ein Frequenzkamm erzeugt und in Ausbreitungsrichtung in ein optisch nichtlineares Medium (4) eingekoppelt wird,
   wobei Pumpwellen von zwei Pumpquellen (5, 6) erzeugt und entgegen der Ausbreitungsrichtung in das optisch nichtlineare Medium (4) eingekoppelt werden,

wobei die Wellenlängen der Pumpwellen derart eingestellt werden, dass sie zwei Frequenzen aus dem Frequenzkamm vermittels stimulierter Brillouin Streuung verstärken,

wobei die beiden verstärkten Frequenzen in Ausbreitungsrichtung aus dem Medium (4) ausgekoppelt und in einem zweiten Photosensor (12) heterodyn überlagert werden und

wobei die Überlagerung einem Ausgangssignal des zweiten Photosensors (12) eine Differenzfrequenz aufprägt, die ausgekoppelt wird,

**dadurch gekennzeichnet,**

**dass** der Frequenzkamm mittels einer einzigen modengekoppelten Laserquelle (1) erzeugt und mittels eines ersten Zirkulators (3) in das optisch nichtlineare Medium (4) eingekoppelt wird, dass die Pumpwellen unter Verwendung eines mit dem ersten Zirkulator (3) verbundenen ersten Photosensors (14) auf die beiden zu verstärkenden Frequenzen mittels des Pound-Drever-Hall-Verfahrens stabilisiert werden und

**dass** nicht zu verstärkende Frequenzen des Frequenzkamms vermittels des "Polarization Pulling" Effektes unterdrückt werden, wobei der "Polarization Pulling" Effekt erzeugt wird durch einen vor dem zweiten Photosensor (12) angeordneten Polarisationsfilter (11) und ein in Ausbreitungsrichtung der Pumpstrahlung hinter einer Pumpquelle angeordnetes Polarisationsstellglied (7, 8) zur Polarisierung der Pumpstrahlung parallel zum Polarisationsfilter (11), wobei in Ausbreitungsrichtung des Frequenzkammes vor dem ersten Zirkulator (3) ein Polarisationssteller (2) zur Polarisierung der Strahlung des Frequenzkammes senkrecht zum Polarisationsfilter (11) vorgesehen ist.

2. Verfahren nach Anspruch 1,
**dadurch gekennzeichnet,**
**dass** die Bandbreite des Frequenzkamms durch nichtlineare Effekte, wie die Selbstphasenmodulation und die Vierwellenmischung, erweitert wird.

3. Verfahren nach Anspruch 1,
**dadurch gekennzeichnet,**
**dass** eine zu verstärkende Frequenz durch Änderung der Pumpwellenlänge eines Pumplasers (5 ,6) und/oder Änderung der Repetitionsrate des Kurzpulslasers (1) eingestellt wird.

4. System zur Umsetzung des Verfahrens nach einem der vorherigen Ansprüche,
aufweisend eine Laserquelle (1) zur Erzeugung eines Frequenzkammes, aufweisend ein Polarisationsstellglied (2) und einen ersten Zirkulator (3) zur Einkoppelung des Frequenzkammes in ein Brillouin Medium (4) in Ausbreitungsrichtung,
aufweisend zwei Pumpquellen (5, 6) zur Erzeugung von Pumpwellen, aufweisend ein Koppelglied (9) zur Zusammenführung der Pumpwellen aufweisend einen zweiten Zirkulator (10) zur Einkoppelung der zusammengeführten Pumpwellen in das Brillouin Medium (4) entgegen der Ausbreitungsrichtung,
wobei der erste Zirkulator (3) einen Ausgang zur Auskoppelung der Pumpwellen aufweist, der mit einem ersten Photosensor (14) verbunden ist, wobei der zweite Zirkulator (10) einen Ausgang zur Auskoppelung der verstärkten Frequenzen des Frequenzkammes aufweist, der mit einem zweiten Photosensor (12) verbunden ist,
**dadurch gekennzeichnet,**
**dass** die Laserquelle (1) eine modengekoppelte Laserquelle ist,
**dass** ein Ausgang des ersten Photosensors (14) mit einer auf dem Pound-Drever-Hall-Verfahren beruhenden Stabilisierungsschaltung (13) verbunden ist, deren Ausgangssignal die Pumpquellen (5,6) auf die beiden zu verstärkenden Frequenzen stabilisiert,
**dass** vor dem zweiten Photosensor (12) ein Polarisationsfilter (11) vorgesehen ist, wobei in Ausbreitungsrichtung der Pumpstrahlung hinter einer Pumpquelle ein Polarisationsstellglied (7, 8) zur Polarisierung der Pumpstrahlung parallel zum Polarisationsfilter (11) vorgesehen ist und in Ausbreitungsrichtung des Frequenzkammes vor dem ersten Zirkulator (3) ein Polarisationssteller (2) zur Polarisierung der Strahlung des Frequenzkammes senkrecht zum Polarisationsfilter (11) vorgesehen ist.

5. System nach Anspruch 4,
**dadurch gekennzeichnet,**
**dass** die Pumpquellen Laserdioden sind.

6. System nach Anspruch 4 oder 5,
**dadurch gekennzeichnet,**
**dass** die Photosensoren Photodioden sind.

**7.** System nach einem der Ansprüche 4 bis 6,
**dadurch gekennzeichnet,**
**dass** das Brillouin Medium (4) eine Singlemode Faser mit einer Länge von mehreren Kilometern ist.

**Claims**

**1.** A method for generating millimetre or terahertz waves by overlaying two optical waves of different frequency,
a frequency comb being created and coupled into an optically non-linear medium (4) in the propagation direction,
pump waves being generated by two pump sources (5, 6) and coupled into the optically non-linear medium (4) counter to the propagation direction,
the wavelengths of the pump waves being set in such a manner that they amplify two frequencies from the frequency comb by means of stimulated Brillouin scattering,
the two amplified frequencies being decoupled from the medium (4) in the propagation direction and overlaid in a second photosensor (12) in a heterodyne manner, and
the overlaying applying a differential frequency on an output signal of the second photosensor (12), which differential frequency is decoupled,
**characterized**
**in that** the frequency comb is created by means of a single mode-coupled laser source (1) and coupled into the optically non-linear medium (4) by means of a first circulator (3),
**in that** the pump waves are stabilized to the two frequencies to be amplified by means of the Pound-Drever-Hall method using a first photosensor (14) connected to the first circulator (3), and
**in that** frequencies of the frequency comb which are not to be amplified are suppressed by means of the "polarization pulling" effect, wherein the "polarization pulling" effect is generated by means of a polarization filter (11) arranged upstream of the second photosensor (12) and a polarization control element (7, 8) for polarizing the pump radiation parallel to the polarization filter (11), which polarization control element is arranged downstream of a pump source in the propagation direction of the pump radiation, wherein a polarization controller (2) for polarizing the radiation of the frequency comb perpendicularly to the polarization filter (11) is provided upstream of the first circulator (3) in the propagation direction of the frequency comb.

**2.** The method according to Claim 1,
**characterized**
**in that** the bandwidth of the frequency comb is expanded by non-linear effects, such as self-phase modulation and four-wave mixing.

**3.** The method according to Claim 1,
**characterized**
**in that** a frequency to be amplified is set by changing the pump wavelength of a pump laser (5, 6) and/or changing the repetition rate of the short-pulse laser (1) .

**4.** A system for implementing the method according to one of the preceding claims,
having a laser source (1) for creating a frequency comb,
having a polarization control element (2) and a first circulator (3) for coupling the frequency comb into a Brillouin medium (4) in the propagation direction, having two pump sources (5, 6) for generating pump waves,
having a coupling element (9) for combining the pump waves,
having a second circulator (10) for coupling the combined pump waves into the Brillouin medium (4) counter to the propagation direction,
the first circulator (3) having an output for decoupling the pump waves, which output is connected to a first photosensor (14),
the second circulator (10) having an output for decoupling the amplified frequencies of the frequency comb, which output is connected to a second photosensor (12),
**characterized**
**in that** the laser source (1) is a mode-coupled laser source,
**in that** an output of the first photosensor (14) is connected to a stabilization circuit (13) based on the Pound-Drever-Hall method, the output signal of which stabilizes the pump sources (5, 8) to the two frequencies to be amplified,
**in that** a polarization filter (11) is provided upstream of the second photosensor (12), wherein a polarization control element (7, 8) for polarizing the pump radiation parallel to the polarization filter (11) is provided downstream of a pump source in the propagation direction of the pump radiation, and a polarization controller (2) for polarizing the radiation of the frequency comb perpendicularly to the polarization filter (11) is provided upstream of the first circulator (3) in the propagation direction of the frequency comb.

5. The system according to Claim 4,
   **characterized**
   **in that** the pump sources are laser diodes.

6. The system according to Claim 4 or 5,
   **characterized**
   **in that** the photosensors are photodiodes.

7. The system according to one of Claims 4 to 6,
   **characterized**
   **in that** the Brillouin medium (4) is a single-mode fibre with a length of several kilometres.

**Revendications**

1. Procédé, destiné à générer des ondes millimétriques ou des ondes térahertz par superposition de deux ondes optiques de fréquence différente,
   lors duquel un peigne de fréquences est généré et dans la direction de propagation, est injecté dans un milieu (4) optiquement non linéaire,
   lors duquel des ondes de pompe sont générées par deux sources de pompage (5, 6) et injectées à l'encontre de la direction de propagation dans le milieu (4) optiquement non linéaire,
   lors duquel les longueurs d'onde des ondes de pompe sont réglées de sorte à amplifier deux fréquences issues du peigne de fréquences par dispersion Brillouin stimulée,
   lors duquel les deux fréquences amplifiées sont extraites dans la direction de propagation hors du milieu (4) et superposées par voie hétérodyne dans un photocapteur (12),
   la superposition imprimant à un signal de sortie du deuxième photocapteur (12) une fréquence différentielle qui est extraite,
   **caractérisé**
   **en ce que** le peigne de fréquences est généré au moyen d'une unique source laser (1) en mode bloqué et injecté au moyen d'un premier circulateur (3) dans le milieu (4) optiquement non linéaire,
   **en ce qu'**en utilisant un premier photocapteur (14) - relié avec le premier circulateur (3), les ondes de pompe sont stabilisées sur les deux fréquences qui doivent être amplifiées au moyen du procédé Pound-Drever-Hall et
   **en ce que** des fréquences du peigne de fréquence qui ne doivent pas être amplifiées sont supprimées par effet de « Polarization Pulling », sachant que l'effet de « Polarization Pulling » est généré par un filtre polarisant (11) placé à l'avant du deuxième photocapteur (12) et par un actionneur de polarisation (7, 8) placé derrière une source de pompage dans la direction de propagation du rayonnement de pompage pour la polarisation du rayonnement de pompage à la parallèle du filtre polarisant (11), sachant que dans la direction de propagation du peigne de fréquences, à l'avant du premier circulateur (3), il est prévu un régleur de polarisation (2) pour polariser le rayonnement du peigne de fréquences à la perpendiculaire du filtre polarisant (11).

2. Procédé selon la revendication 1, **caractérisé en ce que** la bande passante du peigne de fréquences est élargie par des effets non linéaires, comme l'automodulation de phase et le mélange à quatre ondes.

3. Procédé selon la revendication 1, **caractérisé en ce qu'**une fréquence qui doit être amplifiée est réglée par modification de la longueur d'onde de pompage d'un laser de pompage (5 ,6) et/ou par modification du taux de répétition du laser à impulsions courtes (1).

4. Système, destiné à la mise en oeuvre du procédé selon l'une quelconque des revendications précédentes, comportant une source laser (1) destinée à générer un peigne de fréquences, comportant un actionneur de polarisation (2) et un premier circulateur (3), destiné à injecter le peigne de fréquences dans un milieu Brillouin (4), dans la direction de propagation,
   comportant deux sources de pompage (5, 6), destinées à générer des ondes de pompe, comportant un organe d'accouplement (9), destiné à réunir les ondes de pompe, comportant un deuxième circulateur (10), destiné à injecter les ondes de pompe réunies dans le milieu Brillouin (4) à l'encontre de la direction de propagation,
   le premier circulateur (3) comportant une sortie pour l'extraction des ondes de pompe, qui est reliée avec un premier photocapteur (14), le circulateur (10) comportant une sortie pour l'extraction des fréquences amplifiées du peigne de fréquences, qui est reliée avec un deuxième photocapteur (12),
**caractérisé**
**en ce que** la source laser (1) est une source laser en mode bloqué,
**en ce qu'**une sortie du premier photocapteur (14) est reliée avec un circuit de stabilisation (13) reposant sur le procédé Pound-Drever-Hall, dont le signal de sortie stabilise les sources de pompage (5,6) sur les deux fréquences qui doivent être amplifiées,
**en ce qu'**à l'avant du deuxième photocapteur (12) est prévu un filtre polarisant (11}, dans la direction de propagation du rayonnement de pompage, à l'arrière d'une source de pompage est prévu un actionneur de polarisation (7, 8), destiné à polariser le rayonnement de pompage à la parallèle du filtre polarisant (11) et dans la direction de propagation du peigne de fréquences, à l'avant du premier circulateur (3) est prévu un régleur de polarisation (2), destiné à polariser le rayonnement du peigne de fréquences, à la perpendiculaire du filtre polarisant (11).

5. Système selon la revendication 4, **caractérisé en ce que** les sources de pompage sont des diodes laser.

6. Système selon la revendication 4 ou 5, **caractérisé en ce que** les photocapteurs sont des photodiodes.

7. System selon l'une quelconque des revendications 4 à 6, **caractérisé en ce que** le milieu Brillouin (4) est une fibre monomode, d'une longueur de plusieurs kilomètres.

Fig. 1

Fig. 2

**Fig. 3**

**Fig. 4**

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080310464 A

- DE 102006023601 A1

**In der Beschreibung aufgeführte Nicht-Patentliteratur**

- Theoretical and experimental investigation of Brillouin scattering for the generation of millimeter waves. **T. SCHNEIDER et al.** Journal of the optical society of america - B. optical society of america, 01. Juni 2006, vol. 23, 1012-1019